# EUROPÄISCHE PATENTSCHRIFT

(11) **EP 4 312 032 B1**
(45) Veröffentlichungstag und Bekanntmachung des Hinweises auf die Patenterteilung: **22.01.2025**
(21) Anmeldenummer: 22187261.7
(22) Anmeldetag: 27.07.2022
(51) Int. Cl.: G01R 15/06, G01R 15/14, G01R 15/18, G01R 19/00, H05H 1/00, H05H 1/46

(54) **MESSVORRICHTUNG FÜR WECHSELSTRÖME UND -HOCHSPANNUNGEN VON PHYSIKALISCHEN PLASMEN**
MEASURING DEVICE FOR ALTERNATING CURRENTS AND HIGH VOLTAGES OF PHYSICAL PLASMAS
DISPOSITIF DE MESURE POUR COURANTS ALTERNATIFS ET HAUTE TENSION DES PLASMAS PHYSIQUES

(43) Veröffentlichungstag der Anmeldung: 31.01.2024
(73) Patentinhaber: Hochschule für Angewandte Wissenschaft und Kunst Hildesheim/Holzminden/Göttingen, 31134 Hildesheim (DE)
(72) Erfinder: Hesse, Mario, 37075 Göttingen (DE); Schulz, Jannik, 37077 Göttingen (DE); Damm, Roland, 37136 Ebergötzen (DE); Viöl, Wolfgang, 37139 Adelebsen (DE)
(74) Vertreter: REHBERG HÜPPE + PARTNER

(56) Entgegenhaltungen:
- WO-A1-99/42845
- DE-U1- 202007 012 065
- US-A1- 2002 190 705
- US-B2- 7 345 428

## Beschreibung

### TECHNISCHES GEBIET DER ERFINDUNG

Die Erfindung bezieht sich auf eine Messvorrichtung für Wechselströme und -hochspannungen von physikalischen Plasmen, insbesondere von kalten Atmosphärendruckplasmen, sowie auf einen Plasmagenerator mit einer Wechselhochspannungsquelle, einer über eine Hochspannungsleitung an die Wechselhochspannungsquelle angeschlossenen Plasmaelektrode und einer solchen Messvorrichtung.

Um das Zünden von physikalischen Plasmen zu steuern und/oder den Zustand von physikalischen Plasmen zu überwachen ist es sinnvoll, die an einer Plasmaelektrode anliegenden Wechselhochspannungen und die über die Plasmaelektrode fließenden Wechselströme zu erfassen. Das Produkt dieser Wechselhochspannungen und Wechselströme ist eine elektrische Leistung, die im Wesentlichen in dem physikalischen Plasma umgesetzt wird.

Es geht also speziell um das Zünden und Überwachen von physikalischen Plasmen, die durch Anlegen einer Wechselhochspannung an eine Plasmaelektrode und resultierende Gasentladungen gegenüber einem Bezugspotential wie der elektrischen Erde hervorgerufen werden. Noch spezieller geht es um kalte Atmosphärendruckplasmen, bei denen die Gasentladungen dielektrisch behindert sind.

### STAND DER TECHNIK

Wechselhochspannungsquellen von Plasmageneratoren weisen vielfach einen Transformator auf, um eine an einer Primärwicklung des Transformators anliegende Wechselspannung in eine Wechselhochspannung zu transformieren. Beispielsweise aus der WO 2010 / 098 779 A1 ist es bekannt, den Verlauf der über der Primärwicklung eines solchen Transformators abfallenden Wechselspannungen und die Stromstärke der durch die Primärwicklung fließenden Wechselströme mit getrennten Spannungsmessköpfen und Stromwandlern zu messen und hieraus auf den Verlauf der Wechselhochspannungen und die Stromstärke der Wechselströme auf der Sekundärseite des Transformators zu schließen, die über den auf der Sekundärseite erzeugten physikalischen Plasmen abfallen bzw. durch diese fließen. Diese indirekte Messung der Wechselströme und -hochspannungen von physikalischen Plasmen erweist sich jedoch als ungenau.

Zum potentialfreien Messen von Wechselströmen durch Leitungen sind sogenannte Stromwandler bekannt. Ein Stromwandler weist einen Ringkern auf, der die jeweilige Leitung umschließt. Auf dem Ringkern ist eine Messwicklung angeordnet. Von einem durch die Leitung fließenden Wechselstrom wird ein magnetisches Wechselfeld in dem Ringkern induziert, dass eine Spannung zwischen den Enden der Messwicklung hervorruft. Eine Messwechselspannung, die über einem zwischen die Enden der Messwicklung geschalteten Messwiderstand abfällt, ist eine monoton steigende Funktion der Stromstärke der durch die Leitung fließenden Wechselströme. Auf der Webseite www.pearson.com werden verschiedene Stromwandler angeboten, zum Teil mit aufklappbaren Ringkern und/oder mit Führung für die jeweilige Leitung durch den Ringkern.

### AUFGABE DER ERFINDUNG

Der Erfindung liegt die Aufgabe zugrunde, eine Messvorrichtung für Wechselströme und -hochspannungen von physikalischen Plasmen, insbesondere von kalten Atmosphärendruckplasmen, sowie einen Plasmagenerator mit einer solchen Messvorrichtung aufzuzeigen, bei denen die über die Plasmaelektrode fließenden Wechselströme und die daran anliegenden Wechselhochspannungen mit möglichst geringem Aufwand möglichst direkt und genau gemessen werden.

### LÖSUNG

Die Aufgabe der Erfindung wird durch eine Messvorrichtung mit den Merkmalen des unabhängigen Patentanspruchs 1 und durch einen Plasmagenerator mit den Merkmalen des nebengeordnetem Patentanspruchs 9 gelöst. Die abhängigen Patentansprüche 2 bis 8 und 10 betreffen bevorzugte Ausführungsformen der erfindungsgemäßen Messvorrichtung und des erfindungsgemäßen Plasmagenerators.

### BESCHREIBUNG DER ERFINDUNG

Eine erfindungsgemäße Messvorrichtung für Wechselströme und -hochspannungen von physikalischen Plasmen weist einen Stromwandler mit einem Ringkern und einer Messwicklung auf dem Ringkern, eine Leitungsführung, die dazu ausgebildet ist, eine von einer Wechselhochspannungsquelle zu einer Plasmaelektrode verlaufende Hochspannungsleitung in definierter Relativanordnung durch den Ringkern zuführen, einen zwischen Enden der Messwicklung geschalteten Messwiderstand und eine zwischen einen Mittelpunktanzapf der Messwicklung und einen Bezugspotentialanschluss geschaltete Messkapazität auf. Eine über den Messwiderstand abfallende und dort abgreifbare erste Messwechselspannung ist eine erste streng monoton steigende Funktion einer Stromstärke der durch die Hochspannungsleitung zu der Plasmaelektrode fließenden Wechselströme; und eine über der Messkapazität abfallende zweite Messwechselspannung ist eine streng monoton steigende Funktion eines Verlaufs der über die Hochspannungsleitung gegenüber einem an dem Bezugspotentialanschluss angeschlossenen Bezugspotential an der Plasmaelektrode anliegenden Wechselhochspannung. Bei üblicher Auslegung des Ringkerns des Stromwandlers handelt es sich bei den streng monoton steigenden Funktionen um lineare Funktionen der Stromstärke der Wechselströme beziehungsweise der Verläufe der Wechselspannungen. Zudem stimmen die Frequenzen der Messwechselspannungen mit denen der Wechselströme beziehungsweise Wechselhochspannungen überein. Soweit Phasenverschiebungen zwischen den Messwechselspannungen und den Wechselströmen beziehungsweise Wechselspannungen vorliegen, die frequenzabhängig sein können, können diese einmalig erfasst und anschließend einfach kompensiert werden.

Für die Messung der Wechselströme nutzt die erfindungsgemäße Messvorrichtung das bekannte Prinzip eines Stromwandlers. Für die Messung der Wechselhochspannungen nutzt die erfindungsgemäße Messvorrichtung aus, dass Primärwicklung und Sekundärwicklung eines Transformators und so auch die durch den Ringkern führende Hochspannungsleitung und die Messwicklung bei der erfindungsgemäßen Messvorrichtung immer nicht nur induktiv, sondern auch kapazitiv gekoppelt sind, d. h. ohne dass irgendein Kondensator zwischen die Primärwicklung beziehungsweise Hochspannungsleitung einerseits und die Sekundärwicklung beziehungsweise die Messwicklung andererseits geschaltet wäre. Aus dieser inhärenten kapazitiven Kopplung resultiert die zweite Messwechselspannung, die über der zwischen den Mittelpunktanzapf der Messwicklung und das Bezugspotential geschalteten Messkapazität abfällt. Die Kapazität der inhärenten kapazitiven Kopplung zwischen der Hochspannungsleitung und der Messwicklung erweist sich als konstant, solange die Relativanordnung des Ringkerns und der durch diesen geführten Hochspannungsleitung gleich bleibt, was durch die Leitungsführung der erfindungsgemäßen Messvorrichtung sicher gestellt wird. Die Kapazität der inhärenten kapazitiven Kopplung ist zwar nur klein, und liegt in einer typischen Größenordnung von wenigen Picofarad, d. h. beispielsweise zwischen 1 und 10 pF. Gerade dies erlaubt es jedoch, mit einer relativ kleinen Messkapazität im nF-Bereich einen kapazitiven Spannungsteiler auszubilden, so dass bei Wechselhochspannungen einer Größenordnung von 10.000 V eine einfach verwendbare zweite Messwechselspannung im Voltbereich über der Messkapazität abfällt.

Die Messkapazität hat auch zur Folge, dass die erste Messwechselspannung einen festen Bezug zu dem Bezugspotential hat. Die Messkapazität kann durch einen Kondensator oder mehrere miteinander verschaltete Kondensatoren realisiert sein.

Die Leitungsführung der erfindungsgemäßen Messvorrichtung kann insbesondere dazu ausgebildet sein, die Hochspannungsleitung koaxial durch den Ringkern zuführen. Die Leitungsführung kann ein sich einerseits an dem Ringkern oder einem Gehäuse des Ringkerns abstützender und andererseits die Hochspannungsleitung abstützender Formkörper sein. Dieser Formkörper kann 3D-gedruckt sein, um ihn an den jeweiligen Ringkern beziehungsweise dessen Gehäuse und die jeweilige Hochspannungsleitung anzupassen. Der Einsatz kann mehrteilig sein, um ihn um die jeweilige Hochspannungsleitung zusammenzufügen. Auch der Ringkern kann aufklappbar sein, um ihn um die jeweilige Leitungsführung und die jeweilige Umspannungsleitung zusammenfügen zu können. Es versteht sich, dass die Leitungsführung aus einem nicht magnetischen und nicht elektrisch leitfähigen Material auszubilden ist und insbesondere aus Kunststoff ausgebildet sein kann.

Bei der erfindungsgemäßen Messvorrichtung kann zwischen Anschlüsse des Messwiderstands und Abgriffspunkte für die erste Messwechselspannung ein erstes Tiefpassfilter geschaltet sein. Dieses Tiefpassfilter kann beispielsweise ein RC-Glied aufweisen. Eine erste Grenzfrequenz des ersten Tiefpassfilters kann abhängig von einer Abtastrate eines ersten A/D-Wandlers für die erste Messwechselspannung gewählt werden, sodass beim Abtasten eines Signals mit der Grenzfrequenz das Nyquist-Shannon-Kriterium gewahrt bleibt, nach dem die Abtastrate für das fehler- und artefaktfreie Abtasten eines Signals mit einer Signalfrequenz mindestens doppelt so groß sein muss wie die Signalfrequenz.

Zwischen Anschlüsse der Messkapazität und Abgriffspunkte für die zweite Messwechselspannung kann ein zweites Tiefpassfilter geschaltet sein. Dieses zweite Tiefpassfilter kann ein zweites RC-Glied aufweisen. Eine zweite Grenzfrequenz des zweiten Tiefpassfilters kann auf eine Abtastrate eines zweiten A/D-Wandlers für die Messwechselspannung abgestimmt sein, wobei auch hier das Nyquist-Shannon-Kriterium zu beachten ist.

Typischerweise werden die erste Grenzfrequenz des ersten Tiefpassfilters und die zweite Grenzfrequenz des zweiten Tiefpassfilters gleich sein, ebenso wie eine erste Abtastrate des ersten A/D-Wandlers für die erste Messwechselspannung und eine zweite Abtastrate eines zweiten A/D-Wandlers für die zweite Messwechselspannung gleich sein werden. Zudem können der erste und der zweite A/D-Wandler bezüglich ihrer Abtastraten synchronisiert sein.

Aus den an der erfindungsgemäßen Messvorrichtung abgegriffenen ersten und zweiten Messwechselspannungen kann die elektrische Leistung des jeweiligen Plasmas berechnet werden. Es ist aber auch möglich, in der erfindungsgemäßen Messvorrichtung einen analogen Multiplizierer für die erste Messwechselspannung und die zweite Messwechselspannung vorzusehen, der eine Produktspannung ausgibt. Diese Produktspannung ist dann unmittelbar proportional zu der interessierenden elektrischen Leistung des Plasmas. Es versteht sich, dass für die Produktspannung ein weiteres Tiefpass-Filter und/oder ein weiterer A/D-Wandler vorhanden sein kann.

Bei einem erfindungsgemäßen Plasmagenerator mit einer Wechselhochspannungsquelle, die dazu ausgebildet ist, an einem Hochspannungsleitungsanschluss eine Wechselhochspannung gegenüber ein Bezugspotential auszugeben, einer Plasmaelektrode, die dazu ausgebildet ist, um bei anliegender Wechselhochspannung durch elektrische Entladung gegenüber dem Bezugspotential ein physikalisches Plasma in einem Arbeitsgas zu zünden, und einer an den Hochspannungsleitungsanschluss und die Plasmaelektrode angeschlossenen Hochspannungsleitung, die dazu ausgebildet ist, die Wechselhochspannung an die Plasmaelektrode anzulegen, ist eine erfindungsgemäße Messvorrichtung für Wechselströme und -spannungen des physikalischen Plasmas vorhanden.

Bei dem erfindungsgemäßen Plasmagenerator kann eine dielektrische Abschirmung der Plasmaelektrode dazu ausgebildet sein, die elektrischen Entladungen gegenüber dem Bezugspotential dielektrisch zu behindern. Eine dielektrische Behinderung der elektrischen Entladung kann alternativ auch durch eine kapazitive Ankopplung der Plasmaelektrode an die Hochspannungsleitung bewirkt werden. Durch die dielektrische Behinderung ist der erfindungsgemäße Plasmagenerator insbesondere zum Erzeugen kalter Atmosphärendruckplasmen geeignet.

Ganz allgemein gilt, dass die erfindungsgemäße Messvorrichtung mit ihrem Stromwandler nur Wechselströme und Wechselspannungen messen kann. Für die Messung von Gleichströmen und Gleichspannungen von Plasmen und entsprechende mit Gleichspannung arbeitende Plasmageneratoren ist sie nicht geeignet. Die erfindungsgemäße Messvorrichtung erkennt auch keinen einem Wechselstrom mit Flussrichtungswechsel überlagerten Gleichstrom und keine einer Wechselspannung mit Polarisationswechsel überlagerte Gleichspannung. Geeignet ist die erfindungsgemäße Messvorrichtung jedoch für jegliche Art von Wechselströmen und -spannungen, d. h. nicht nur für sinusförmige, sondern auch für Wechselströme und - spannungen mit beliebigen Zeitverlauf, insbesondere auch für gepulste Wechselströme und - spannungen.

Es versteht sich, dass sowohl die Kapazität einer dielektrischen Abschirmung der Plasmaelektrode auch einer kapazitiven Ankopplung der Plasmaelektrode an die Hochspannungsleitung bei der Ermittlung der Wechselspannung des Plasmas aus der zweiten Messspannung zu berücksichtigen ist. Wenn jedoch die Wechselspannung direkt mit dem Wechselstrom multipliziert und das resultierende Produkt gemittelt wird, entfallen die Einflüsse jeglicher Kapazitäten auf die Wechselspannung, weil diese nur eine Blindleistung mit wechselndem Vorzeichen, aber keine Wirkleistung zu Folge haben. Wenn keine resistiven Elemente mit dem Plasma elektrisch in Reihe geschaltet sind, ist die so oder auf andere Weise aus der Wechselspannung und dem Wechselstrom bestimmte Wirkleistung diejenige des Plasmas.

Vorteilhafte Weiterbildungen der Erfindung ergeben sich aus den Patentansprüchen, der Beschreibung und den Zeichnungen.

Hinsichtlich des Offenbarungsgehalts - nicht des Schutzbereichs - der ursprünglichen Anmeldungsunterlagen und des Patents gilt Folgendes: Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen, was aber nicht für die unabhängigen Patentansprüche des erteilten Patents gilt.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einer Plasmaelektrode die Rede ist, ist dies so zu verstehen, dass genau eine Plasmaelektrode, zwei Plasmaelektroden oder mehr Plasmaelektroden vorhanden sind. Die in den Patentansprüchen angeführten Merkmale können durch weitere Merkmale ergänzt werden oder die einzigen Merkmale sein, die der Gegenstand des jeweiligen Patentanspruchs aufweist.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: ist ein Schaltplan eines erfindungsgemäßen Plasmagenerators mit einer erfindungsgemäßen Messvorrichtung, wobei ein mit dem Plasmagenerator erzeugtes Plasma durch ein Ersatzschaltbild wiedergegeben ist; und
- **Fig. 2**: ist eine Prinzipdarstellung einer konkreteren Ausführungsform der erfindungsgemäßen Messvorrichtung.

### FIGURENBESCHREIBUNG

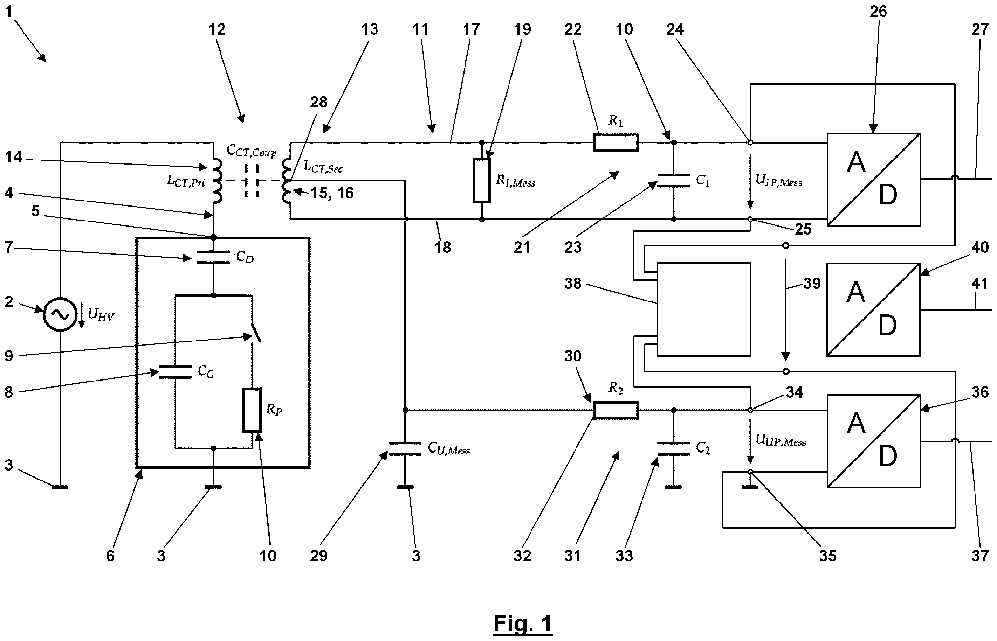

Der in **Fig. 1** dargestellte Plasmagenerator 1 weist eine Wechselhochspannungsquelle 2 auf, die eine Wechselhochspannung U_{HV} gegenüber einem Bezugspotential 3, beispielsweise der elektrischen Erde oder einer anderen elektrischen Masse erzeugt. Die Wechselhochspannung U_{HV} liegt über eine Hochspannungsleitung 4 an einer Plasmaelektrode 5 an. Die Plasmaelektrode 5 ist mit einer dielektrischen Abschirmung versehen, die in einem Plasmamodel 6 in eine Abschirmkapazität C_{D} eines Kondensators 7 eingeht. Ein Kondensator 8 des Plasmamodels 6 steht für eine elektrische Kapazität C_{G}, die sich vor dem Zünden des Plasmas über einem Entladungsspalt ausbildet. Mit dem Zünden des Plasmas wird ein Schalter 9 des Plasmamodells 6 geschlossen. Ein mit dem Schalter 9 in Reihe geschalteter Widerstand 10 repräsentiert den ohmschen Widerstand N_{P} des Plasmas, das durch die Wechselhochspannung U_{HV} gezündet wird, welche gegenüber dem Bezugspotential 3 an der Plasmaelektrode 5 anliegt.

Eine erfindungsgemäße Messvorrichtung 11 zum Messen von Wechselstrom und -spannung des Plasmas weist einen Stromwandler 12 auf, der hier als Transformator mit einer Primärwicklung 14 und einer Sekundärwicklung 15 wiedergeben ist. Praktisch weist der Stromwandler 12 einen in Fig. 1 nicht dargestellten Ringkern auf, auf dem die Sekundärwicklung 15 als Messwicklung 16 angeordnet ist und durch den hindurch die Hochspannungsleitung 4 verläuft, also eine Primärwicklung 14 ohne eine einzige vollständige Windung ausbildet. Dennoch weist die Primärwicklung 14 eine Induktivität L_{CT,Pri} auf, die über den Ringkern induktiv an eine Induktivität L_{CT,Sec} der Sekundärwicklung angekoppelt ist. Darüber hinaus sind die Primärwicklung 14 und die Sekundärwicklung 15 inhärent, d. h. ohne das tatsächliche Vorhandensein eines Kondensators, mit einer Kapazität C_{CT,Coup} kapazitiv gekoppelt. Zwischen Enden 17 und 18 der Messwicklung 16 ist ein Messwiederstand 19 mit einem ohmschen Widerstand R_{I,Mess} geschaltet. Für eine über dem Messwiderstand 19 abfallende erste Messspannung U_{IP,Mess} ist ein erstes Tiefpassfilter 20 mit einem RC-Glied 21 aus einem Widerstand 22 mit einem ohmschen Widerstand N₁ und einem Kondensator 23 mit einer Kapazität C, vorhanden. Für die an Abgriffspunkte 24 und 25 anliegende tiefpassgefilterte erste Messwechselspannung U_{IP,Mess} ist ein erster A/D-Wandler 26 vorgesehen, der ein erstes Messsignal 27 ausgibt. Das erste Messsignal 27 ist proportional zu dem durch die Hochspannungsleitung 4 zu der Plasmaelektrode 5 und damit durch das Plasma fließenden Wechselstrom.

Zwischen einem Mittelpunktanzapf 28 der Messwicklung 16 und dem Bezugspotential 3 ist eine Messkapazität 29 mit einer elektrische Kapazität C_{U,Mess} geschaltet. Zusammen mit der Kopplungskapazität C_{CT,Cuop} bildet die Messkapazität C_{U,Mess} einen kapazitiven Spannungssteiler für die Wechselhochspannung U_{HV} aus. Für eine über der Messkapazität 29 abfallende zweite Messwechselspannung U_{UP,Mess} ist ein zweites Tiefpassfilter 30 mit einem zweiten RC-Glied 31 aus einem zweiten Widerstand 32 mit einem ohmschen Widerstand R₂ und einem zweiten Kondensator 33 mit einer Kapazität C₂ vorgesehen. An zweite Abgriffspunkte 34 und 35 für die tiefpassgefilterte zweite Messwechselspannung U_{UP,Mess} ist ein zweiter A/D-Wandler 36 angeschlossen, der ein zweites Messsignal 37 ausgibt. Das zweite Messsignal 37 ist proportional zu der an der Plasmaelektrode 5 anliegenden Wechselhochspannung U_{HV}. Zusätzlich sind die ersten Messabgriffe 24 und 25 und die zweiten Messabgriffe 34 und 35 an einen analogen Multiplizierer 38 angeschlossen, der eine Produktspannung 39 ausgibt. Für die Produktspannung 39 ist ein weiterer A/D-Wandler 40 vorgesehen, der ein weiteres Messsignal 41 ausgibt. Das Messsignal 41 ist zu der elektrischen Leistung des Plasmas proportional.

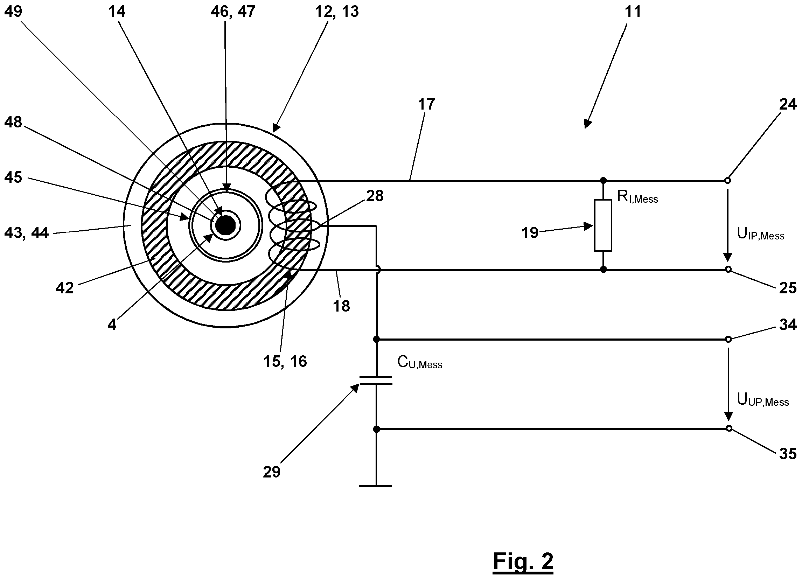

**Fig. 2** zeigt eine konkretere Ausführung des Stromwandlers 12 mit dem Ringkern 42, auf der die Messwicklung 16 angeordnet ist und durch den die Hochspannungsleitung 4 hindurchführt. Der Ringkern 42 ist zusammen mit der Messwicklung 16 in eine nicht magnetische und nicht elektrisch leitende Vergussmasse 43 eingebettet, die ein Gehäuse 44 ausbildet. In eine zentrale Öffnung 45 dieses Gehäuses 44 ist ein Formkörper 46 einer Führung 47 für die Hochspannungsleitung 4 eingesetzt. Der Formkörper 46 liegt an dem Gehäuse 44 und einer Isolierung 48 der Hochspannungsleitung 4 an, die deren elektrisch leitenden Kern 49 umschließt. Die Führung 47 führt die Hochspannungsleitung, konkret deren elektrisch leitenden Kern 40 koaxial durch den Ringkern 42. Nicht dargestellt sind in Fig. 2 die Tiefpassfilter 20 und 30, der Multipizierer 38 und die A/D-Wandler 26, 36 und 40 der Messvorrichtung 11.

Bei einer konkreten Ausführungsform der Messvorrichtung 11 betrug die Induktivität L_{CT,Pri} der Primärwicklung 14 des von dem Stromwandler 12 ausgebildeten Transformators 6,40 µH, die Induktivität L_{C,Sec} der Sekundärwicklung 15 auf jeder Seite des Mittelpunktanzapfs 28 3,10 mH und die Kopplungskapazität C_{CT,Cuop} 6,0 pF. Der ohmsche Widerstand R₁ des Messwiderstands 19 mit betrug beispielsweise 6, 12 oder 24 Ohm, typischerweise also weniger als 50 Ohm. Die Anzahl der Windungen der Sekundärwicklung betrug 24. Die ohmschen Widerstände R₁ und R₂ der Widerstände 22 und 32 der RC-Glieder 21 und 31 betrugen 80 Ohm, die Kapazitäten C₁ und C₂ der Kondensatoren 23 und 33 der RC-Glieder 21 und 31 10 pF. Die Messkapazität C_{U,Mess} lag bei 60 nF. Mit dieser Messvorrichtung wurden Plasmaströme und Plasmaspannungen im Bereich von 10 A und 30.000 V mit einer Abtastrate von 500 MHz erfolgreich zeitaufgelöst gemessen.

### BEZUGSZEICHENLISTE

- 1: Plasmagenerator
- 2: Wechselhochspannungsquelle
- 3: Bezugspotential
- 4: Hochspannungsleitung
- 5: Plasmaelektrode
- 6: Plasmamodel
- 7: Kondensator
- 8: Kondensator
- 9: Schalter
- 10: Widerstand
- 11: Messvorrichtung
- 12: Stromwandler
- 13: Transformator
- 14: Primärwicklung
- 15: Sekundärwicklung
- 16: Messwicklung
- 17: Ende der Messwicklung 16
- 18: Ende der Messwicklung 16
- 19: Messwiderstand
- 20: Tiefpassfilter
- 21: RC-Glied
- 22: Widerstand
- 23: Kondensator
- 24: Erster Abgriffspunkt
- 25: Erster Abgriffspunkt
- 26: A/D-Wandler
- 27: Erstes Messsignal
- 28: Mittelpunktanzapf
- 29: Mittelpunkt der Lichtmesskapazität
- 30: Tiefpassfilter
- 31: RC-Glied
- 32: Widerstand
- 33: Kondensator
- 34: Zweiter Abgriffspunkt
- 35: Zweiter Abgriffspunkt
- 36: A/D-Wandler
- 37: Zweites Messsignal
- 38: Multiplizierer
- 39: Produktspannung
- 40: A/D-Wandler
- 41: Weiteres Messsignal
- 42: Ringkern
- 43: Vergussmasse
- 44: Gehäuse
- 45: Öffnung
- 46: Formkörper
- 47: Führung
- 48: Isolierung
- 49: Kern
- U_{HV}: Wechselhochspannung

- C_{D}: Kapazität einer dielektrischen Abschirmung der Plasmaelektrode 5
- C_{G}: Kapazität des Arbeitsgases im Entladungsspalt vor dem Zünden des Plasmas
- R_{P}: ohmscher Widerstand des gezündeten Plasmas
- L_{CT,Pri}: Induktivität der Primärwicklung 14
- L_{CT,Sec}: Induktivität der Sekundärwicklung 15
- C_{CT,Coup}: Kopplungskapazität zwischen Primärwicklung 14 und Sekundärwicklung 15
- R_{I,Mess}: ohmscher Widerstand des Messwiderstands 19
- R₁: ohmscher Widerstand des Widerstands 22
- C₁: Kapazität des Kondensators 23
- U_{IP,Mess}: erste Messwechselspannung
- C_{U,Mess}: elektrische Kapazität der Messkapazität 29
- R₂: ohmscher Widerstand des Widerstands 32
- C₂: Kapazität des Kondensators 33
- U_{UP,Mess}: zweite Messwechselspannung

## Patentansprüche

1. Messvorrichtung (11) für Wechselströme und -spannungen von physikalischen Plasmen, insbesondere von kalten Atmosphärendruckplasmen, mit
- einem Stromwandler (12), der einen Ringkern (42) und eine Messwicklung (16) auf dem Ringkern (42) aufweist,
- einer Leitungsführung (47), die dazu ausgebildet ist, eine von einer Wechselhochspannungsquelle (2) zu einer Plasmaelektrode (5) verlaufende Hochspannungsleitung (4) in definierter Relativanordnung durch den Ringkern (42) zu führen, und
- einem zwischen Enden (17, 18) der Messwicklung (16) geschalteten Messwiderstand (19),
- wobei eine über dem Messwiderstand (19) abfallende erste Messwechselspannung (U_{IP,Mess}) eine erste streng monoton steigende Funktion einer Stromstärke der durch die Hochspannungsleitung (4) zu der Plasmaelektrode (5) fließenden Wechselströme ist,
**dadurch gekennzeichnet,**
- **dass** eine Messkapazität (29) zwischen einen Mittelpunktanzapf (28) der Messwicklung (16) und einen Bezugspotentialanschluss geschaltet ist,
- wobei eine über der Messkapazität (29) abfallende zweite Messwechselspannung (U_{UP,Mess}) eine zweite streng monoton steigende Funktion einer Amplitude einer über die Hochspannungsleitung (4) an der Plasmaelektrode (5) anliegenden Wechselhochspannung (U_{HV}) gegenüber einem an den Bezugspotentialanschluss angeschlossenen Bezugspotential (3) ist.

2. Messvorrichtung (11) nach Anspruch 1, **dadurch gekennzeichnet, dass** die Leitungsführung (47) dazu ausgebildet ist, die Hochspannungsleitung (4) koaxial durch den Ringkern (42) zu führen.

3. Messvorrichtung (11) nach einem der vorhergehenden Ansprüche, **dadurch gekennzeichnet, dass** zwischen Anschlüsse des Messwiderstands (19) und erste Abgriffspunkte (24, 25) für die erste Messwechselspannung (U_{IP,Mess}) ein erstes Tiefpassfilter (20) geschaltet ist.

4. Messvorrichtung (11) nach einem der vorhergehenden Ansprüche, **dadurch gekennzeichnet, dass** zwischen Anschlüsse der Messkapazität und zweite Abgriffspunkte (34, 35) für die zweite Messwechselspannung (U_{UP,Mess}) ein zweites Tiefpassfilter (30) geschaltet ist.

5. Messvorrichtung (11) nach Anspruch 4, soweit rückbezogen auf Anspruch 3, **dadurch gekennzeichnet, dass** eine erste Grenzfrequenz des ersten Tiefpassfilters (20) und eine zweite Grenzfrequenz des zweiten Tiefpassfilters (30) gleich sind.

6. Messvorrichtung (11) nach einem der vorhergehenden Ansprüche, **dadurch gekennzeichnet, dass** ein erster A/D-Wandler (26) für die erste Messwechselspannung (U_{IP,Mess}) und ein zweiter A/D-Wandler (37) für die zweite Messwechselspannung (U_{UP,Mess}) vorhanden sind.

7. Messvorrichtung (11) nach einem der vorhergehenden Ansprüche, **dadurch gekennzeichnet, dass** ein analoger Multiplizierer (38) für die erste Messwechselspannung (U_{IP,Mess}) und die zweite Messwechselspannung (U_{UP,Mess}) vorhanden ist, der eine Produktspannung (39) ausgibt.

8. Messvorrichtung (11) nach Anspruch 7, **dadurch gekennzeichnet, dass** ein weiterer A/D-Wandler (40) für die Produktspannung (39) vorhanden ist.

9. Plasmagenerator (1) mit
- einer Wechselhochspannungsquelle (2), die dazu ausgebildet ist, eine Wechselhochspannung (U_{HV}) gegenüber einem Bezugspotential (3) auszugeben,
- einer Plasmaelektrode (5), die dazu ausgebildet ist, um bei anliegender Wechselhochspannung (U_{HV}) in einem Arbeitsgas ein physikalisches Plasma durch elektrische Entladungen gegenüber dem Bezugspotential (3) zu zünden,
- einer an die Wechselhochspannungsquelle (2) und die Plasmaelektrode (5) angeschlossenen Hochspannungsleitung (4), die dazu ausgebildet ist, die Wechselhochspannung (U_{HV}) an die Plasmaelektrode (5) anzulegen, und
- einer Messvorrichtung (11) nach einem der vorhergehenden Ansprüche für Wechselströme und -spannungen des physikalischen Plasmas.

10. Plasmagenerator (1) nach dem vorhergehenden Anspruch, **dadurch gekennzeichnet, dass** eine dielektrische Abschirmung der Plasmaelektrode (5) dazu ausgebildet ist, die elektrischen Entladungen dielektrisch zu behindern.

## Claims

1. Measurement apparatus (11) for alternating currents and voltages of physical plasmas, particularly of cold plasmas at atmospheric pressure, comprising
- a current transformer (12) having a ring core (42) and a measurement winding (16) on the ring core (42),
- a cable guide (47) configured for guiding a high voltage line (4) running from an alternating high voltage source (2) to a plasma electrode (5) in a defined relative arrangement through the ring core (42), and
- a measurement resistor (19) connected between ends (17, 18) of the measurement winding (16),
- wherein a first measurement alternating voltage (U_{IP,Mess}) dropping over the measurement resistor (19) is a first strictly monotonic increasing function of an amperage of the alternating currents flowing through the high voltage line (4) to the plasma electrode (5),
**characterized in**
- **that** a measurement capacitance (29) is connected between a center tap (28) of the measurement winding (16) and a reference potential connector,
- wherein a second measurement voltage (U_{UP,Mess}) dropping over the measurement capacitance (29) is a second strictly monotonic increasing function of an amplitude of an alternating high voltage (U_{HV}) applied to the plasma electrode (5) via the alternating high voltage with respect to a reference potential (3) connected to the reference potential connector.

2. Measurement apparatus (11) of claim 1, **characterized in that** the cable guide (47) is configured for coaxially guiding the high voltage line (4) through the ring core (42).

3. Measurement apparatus (11) of any of the preceding claims, **characterized in that** a first low pass filter (20) is connected between connections of the measurement resistor (19) and first tap points (24, 25) for the first measurement alternating voltage (U_{IP,Mess}).

4. Measurement apparatus (11) of any of the preceding claims, **characterized in that** a second low pass filter (30) is connected between connections of the measurement capacitance and second tap points (34, 35) for the second measurement alternating voltage (U_{UP,Mess}).

5. Measurement apparatus (11) of claim 4, so far as dependent on claim 3, **characterized in that** a first cut-off frequency of the first low pass filter (20) and a second cut-off frequency of the second low pass filter (30) are equal.

6. Measurement apparatus (11) of any of the preceding claims, **characterized in that** a first A/D converter (26) for the first measurement alternating voltage (U_{IP,Mess}) and a second A/D converter (37) for the second measurement alternating voltage (U_{UP,Mess}) are provided.

7. Measurement apparatus (11) of any of the preceding claims, **characterized in that** an analogous multiplier (38) for the first measurement alternating voltage (U_{IP,Mess}) and the second measurement alternating voltage (U_{UP,Mess}) which puts out a product voltage (39) is provided.

8. Measurement apparatus (11) of claim 7, **characterized in that** a further A/D converter (40) for the product voltage (39) is provided.

9. Plasma generator (1) comprising
- an alternating high voltage source (2) configured for outputting an alternating high voltage (U_{HV}) with respect to a reference potential (3),
- a plasma electrode (5) configured for igniting a physical plasma in a working gas with applied alternating high voltage (U_{HV}) by electric discharges with respect to the reference potential (3),
- a high voltage line (4) connected to the alternating high voltage source (2) and the plasma electrode (5) and configured for applying the alternating high voltage (U_{HV}) to the plasma electrode (5), and
- a measurement apparatus (11) of any of the preceding claims for alternating currents and voltages of the physical plasma.

10. Plasma generator (1) of the preceding claim, **characterized in that** a dielectric barrier of the plasma electrode (5) is configured for dielectrically barring the electric discharges.

## Revendications

1. Dispositif de mesure (11) pour des courants et tensions alternatives de plasmas physiques, plus particulièrement de plasmas à pression atmosphérique, avec
- un convertisseur de courant (12), qui comprend un noyau annulaire (42) et un enroulement de mesure (16) sur le noyau annulaire (42),
- un guidage de ligne (47), qui est conçu pour conduire une ligne à haute tension (4) s'étendant d'une source de haute tension alternative (2) vers une électrode à plasma (5) dans une disposition relative définie à travers le noyau annulaire (42) et
- une résistance de mesure (19) branchée entre les extrémités (17, 18) de l'enroulement de mesure (16),
- dans lequel une première tension alternative de mesure (U_{IP,Mess}) chutant à travers la résistance de mesure (19) est une fonction à croissance strictement monotone d'une intensité des courants alternatifs s'écoulant à travers la ligne à haute tension (4) vers l'électrode à plasma (5),
**caractérisé en ce que**
- un condensateur de mesure (29) est branché entre un raccordement central (28) de l'enroulement de mesure (16) et un raccord de potentiel de référence,
- dans lequel une deuxième tension alternative de mesure (U_{UP,Mess}) chutant à travers le condensateur de mesure (29) est une fonction à croissance strictement monotone d'une haute tension alternative (U_{HV}) appliquée par l'intermédiaire de la ligne à haute tension (4) à l'électrode à plasma (5) par rapport à un potentiel de référence (3) raccordé au raccord de potentiel de référence.

2. Dispositif de mesure (11) selon la revendication 1, **caractérisé en ce que** le guidage de ligne (47) est conçu pour guider la ligne à haute tension (4) de manière coaxiale à travers le noyau annulaire (42).

3. Dispositif de mesure (11) selon l'une des revendications précédentes, **caractérisé en ce que**, entre les raccordements de la résistance de mesure (19) et les points de branchement (24, 25) pour la première tension alternative de mesure (U_{IP,Mess}), est branché un premier filtre passe-bas (20).

4. Dispositif de mesure (11) selon l'une des revendications précédentes, **caractérisé en ce que**, entre les raccordements du condensateur de mesure et les points de branchement (34, 35) pour la deuxième tension alternative de mesure (U_{UP,Mess}), est branché un deuxième filtre passe-bas (30).

5. Dispositif de mesure (11) selon la revendication 4, en référence à la revendication 3, **caractérisé en ce qu'**une première fréquence de base du premier filtre passe-bas (20) et une deuxième fréquence de base du deuxième filtre passe-bas (30) sont identiques.

6. Dispositif de mesure (11) selon l'une des revendications précédentes, **caractérisé en ce qu'**un premier convertisseur A/D (26) pour la première tension alternative de mesure (U_{IP,Mess}) et un deuxième convertisseur A/D (37) pour la deuxième tension alternative de mesure (U_{UP,Mess}).

7. Dispositif de mesure (11) selon l'une des revendications précédentes, **caractérisé en ce qu'**un multiplicateur analogique (38) pour la première tension alternative de mesure (U_{IP,Mess}) et la deuxième tension alternative de mesure (U_{UP,Mess}) est présent, qui génère une tension de produit (39).

8. Dispositif de mesure (11) selon la revendication 7, **caractérisé en ce qu'**un convertisseur A/D (40) supplémentaire pour la tension de produit (39) est présent.

9. Générateur de plasma (1) avec
- une source de haute tension alternative (2), qui est conçue pour générer une haute tension alternative (U_{HV}) par rapport à un potentiel de référence (3),
- une électrode à plasma (5) qui est conçue pour allumer, lorsqu'une haute tension alternative (U_{HV}) est appliquée, dans un gaz de travail, un plasma physique à l'aide de décharges électriques par rapport au potentiel de référence (3),
- une ligne à haute tension (4) branchée à la source de haute tension alternative (2) et à l'électrode à plasma (5), qui est conçue pour appliquer la haute tension alternative (U_{HV}) à l'électrode à plasma (5) et
- un dispositif de mesure (11) selon l'une des revendications précédentes pour des courants et tensions alternatives du plasma physique.

10. Générateur de plasma (1) selon la revendication précédente, **caractérisé en ce qu'**un blindage diélectrique de l'électrode à plasma (5) est conçu pour empêcher de manière diélectrique les décharges électriques.
